(19) Europäisches Patentamt
European Patent Office
Office européen des brevets

(11) **EP 2 641 994 A1**

(12) **EUROPÄISCHE PATENTANMELDUNG**

(43) Veröffentlichungstag:
25.09.2013 Patentblatt 2013/39

(51) Int Cl.:
*C23C 16/04* (2006.01)   *B65D 23/02* (2006.01)
*C23C 16/52* (2006.01)

(21) Anmeldenummer: 12195810.2

(22) Anmeldetag: 06.12.2012

(84) Benannte Vertragsstaaten:
AL AT BE BG CH CY CZ DE DK EE ES FI FR GB
GR HR HU IE IS IT LI LT LU LV MC MK MT NL NO
PL PT RO RS SE SI SK SM TR
Benannte Erstreckungsstaaten:
BA ME

(30) Priorität: 23.03.2012   DE 102012204690

(71) Anmelder: Krones AG
93073 Neutraubling (DE)

(72) Erfinder:
• Krüger, Jochen
93073 Neutraubling (DE)
• Watter, Martin
93073 Neutraubling (DE)

(74) Vertreter: Grünecker, Kinkeldey,
Stockmair & Schwanhäusser
Leopoldstrasse 4
80802 München (DE)

(54) **Vorrichtung zum Plasmabeschichten von Füllgutbehältern, wie Flaschen**

(57) Die Erfindung betrifft eine Vorrichtung und ein Verfahren zur Plasmabeschichtung von Füllgutbehältern, insbesondere Flaschen, wobei die Vorrichtung vorzugsweise eine Rundläufermaschine ist, welche eine Steuereinheit, ein oder mehrere Elektrodensegmente zum Plasmabeschichten, wobei das oder jedes der Elektrodensegmente mindestens einen Füllgutbehälter aufnehmen kann, und Elektroden zum Auskoppeln von Hochfrequenz-Strahlung umfasst, und die Steuereinheit die Plasmabeschichtung in einem oder jedem der Elektrodensegmente automatisch abhängig von Prozessparametern steuern kann.

FIG. 1

Printed by Jouve, 75001 PARIS (FR)

EP 2 641 994 A1

**Beschreibung**

Die Erfindung betrifft eine Vorrichtung zum Plamabeschichten von Füllgutbehältern, wie Flaschen.

**Hintergrund**

Im Stand der Technik gibt es einige Vorrichtungen zur Plasmabeschichtung.

So ist aus der DE 10 2004 028 369 ein Verfahren und eine Vorrichtung zum Behandeln von Substraten in einer Rundläuferanlage bekannt. Diese kann insbesondere zum Beschichten von Kunststoffbehältern in einer Rundläuferanlage verwendet werden. Auf dem Rundläufer sind hier mehrere Behandlungseinrichtungen, die mehrere Prozessphasen in Abhängigkeit von ihrer Winkelposition auf dem Rundläufer durchführen. Dabei ist es möglich, für wenigstens eine der verschiedenen Prozessphasen die Winkelposition in Abhängigkeit von der vorgegebenen Drehgeschwindigkeit des Rundläufers variabel einzustellen.

Diese Vorrichtung hat den Vorteil, dass die Prozessdauer für jede Prozessphase konstant gehalten werden kann, selbst wenn sich die Drehgeschwindigkeit des Rundläufers ändert.

Darüber hinaus zeigt die WO 03/100120 eine Vorrichtung und ein Verfahren zur Behandlung von Werkstücken. Der Vorteil dieses Verfahrens liegt darin, dass es eine Mehrzahl von Behandlungseinrichtungen mit jeweils zumindest einem zu behandelnden Werkstück gibt.

Des Weiteren zeigt die DE 10 2005 015 063 eine Vorrichtung und ein Verfahren zur automatischen Erzeugung von Steueranweisungen für Rundläufermaschinen. Dabei stellt diese Erfindung ein System bereit, das es dem Benutzer ermöglicht, über eine strukturierte Menüführung einen Programmcode zur Steuerung einer Rundläufermaschine zu erstellen. Dies erfolgt in zwei Menüebenen, wobei in der ersten die Definition eines Segments auf dem Rundläufer vorgenommen wird und in der zweiten die Funktion der Rundläufermaschine oder der Bearbeitungsstationen bestimmt wird.

Dies gestattet eine logische Unterteilung des Rundumlaufs in einzelne Segmente, innerhalb derer bestimmte Funktionen gesteuert werden können.

**Aufgabe**

Der Erfindung liegt daher die Aufgabe zugrunde, eine Vorrichtung zum Plasmabeschichten von Füllgutbehältern, wie z.B. Flaschen, zu entwickeln, welche eine hohe Flexibilität und eine Minimierung des Ausschusses ermöglicht.

**Lösung**

Diese Aufgabe ist erfindungsgemäß durch die im Anspruch 1 charakterisierte Vorrichtung und das im Anspruch 11 beschriebene Verfahren gelöst.

Die Unteransprüche beinhalten zweckgemäße Ausgestaltungen der Erfindung.

Die vorliegende Erfindung zeichnet sich dadurch aus, dass jedes der Elektrodensegmente mindestens einen Füllgutbehälter aufnehmen kann und die Steuereinheit die Plasmabeschichtung in einem oder jedem der Elektrodensegmente bzw. auswählbaren Elektrodensegmenten automatisch, abhängig von Prozessparametern, steuern kann. Es ist daher zum Einen möglich, mehrere Füllgutbehälter in einem einzigen Prozessschritt in einem Elektrodensegment zu beschichten und weiterhin ist es möglich, den Prozessablauf an sich ändernde äußere Prozessparameter anzupassen. Dies ist insbesondere von Vorteil, wenn es zu einer zufälligen Änderung von Prozessparametern, wie z.B. Fehlen von einzelnen Füllgutbehältern oder Staus vor bzw. nach der Vorrichtung kommt.

In einer Ausführungsform kann die Steuereinheit die Leistung der Hochfrequenz-Strahlung auf Werte zwischen 0 Watt und einem Wert $L$, welcher bei maximaler Füllgutbehälterbesetzungszahl n und normaler Betriebsgeschwindigkeit $b$, die in der Regel die maximal vorgesehene Betriebsgeschwindigkeit ist, verwendet wird, einstellen. Dadurch lässt sich eine möglichst ideale Anpassung der Leistung der Hochfrequenz-Strahlung an geänderte Prozessparameter erzielen.

In einer weiteren Ausführungsform ist ein Geschwindigkeitssensor vorgesehen, welcher eine momentane Transportgeschwindigkeit $v$ der Füllgutbehälter messen kann und den Wert an die Steuereinheit weitergeben kann oder in der Steuereinheit kann eine momentane Transportgeschwindigkeit $v$ vorgeben werden und die Steuereinheit kann entsprechend einen Antrieb für die Füllgutbehälter steuern. Dies kann dazu beitragen, den Plasmabeschichtungsprozess, insbesondere im Fall von Füllgutbehälterstau vor oder nach der Vorrichtung so anzupassen, dass eine Verstärkung des Staus nach Passieren der Vorrichtung vermieden wird und/oder eine leerstehende Vorrichtung im Fall eines Füllgutbehälterstaus vor der Vorrichtung vermieden wird.

In einer weiteren Ausführungsform steuert die Steuereinheit die Leistung der Hochfrequenzstrahlung in einem oder jedem der Elektrodensegmente in Abhängigkeit von der momentanen Transportgeschwindigkeit $v$ der Füllgutbehälter, wie etwa der Rotationsgeschwindigkeit in der Rundläufermaschine. Dies gestattet es, in jedem Plasmabeschichtungsprozess eines jeden Füllgutbehälters einen stets gleichen Energiebetrag in den jeweiligen Füllgutbehälter über die durch die Elektroden eingekoppelte Hochfrequenz-Strahlung zu deponieren.

In einer weiteren Ausführungsform stellt die Steuereinheit die Leistung $L_1$ der Hochfrequenz-Strahlung gemäß oder basierend auf dem Verhältnis $\dfrac{v}{b}$ aus momentaner Transportgeschwindigkeit $v$ und normaler Betriebsgeschwindigkeit b auf $L_1 = \frac{v}{b} L$ ein.

Dies gestattet es insbesondere bei, im Vergleich zu $b$ , geringerer momentaner Transportgeschwindigkeit $v$ und dadurch vergrößerter Verweildauer der Füllgutbehälter in der Vorrichtung zur Plasmabeschichtung, dennoch den gleichen Energiebetrag im Vergleich zur normalen Betriebsgeschwindigkeit in den Füllgutbehältern zu deponieren.

In einer weiteren Ausführungsform ist eine Erfassungseinrichtung für Füllgutbehälter wie eine Lichtschranke vorgesehen, welche Signale über das Einfahren von Füllgutbehältern in ein oder jedes Elektrodensegment an die Steuereinheit übermitteln kann, welche basierend auf diesen Signalen, eine Anzahl $m$ der Füllgutbehälter in einem oder jedem Elektrodensegment bestimmen kann.

Dies erlaubt eine stetige Kontrolle der Anzahl der Füllgutbehälter in einem oder jedem der Elektrodensegmente und gestattet die Bestimmung der in den Füllgutbehältern deponierten Energie in Abhängigkeit von der Leistung der Hochfrequenz-Strahlung, welche durch die Elektroden ausgekoppelt wird.

In einer weiteren Ausführungsform steuert die Steuereinheit die Leistung der Elektroden in einem oder jedem der Elektrodensegmente in Abhängigkeit von der Anzahl $m$ der Füllgutbehälter.

Dies gestattet eine Anpassung der Leistung der Hochfrequenz-Strahlung, welche durch die Elektroden ausgekoppelt wird und ermöglicht damit beispielsweise eine Reduzierung der Elektrodenleistung bei Anwesenheit von nur weniger Füllgutbehältern als der maximalen Füllgutbehälterbesetzungszahl in einem oder jedem der Elektrodensegmente.

In einer weiteren Ausführungsform stellt die Steuereinheit die Leistung $L_2$ der Hochfrequenz-Strahlung in einem oder jedem der Elektrodensegmente gemäß oder basierend auf dem Verhältnis $\frac{m}{N}$ aus der Anzahl der Füllgutbehälter $m$ in einem oder jedem Elektrodensegment und der maximalen Füllgutbehälterbesetzungszahl $N$ in einem oder jedem Elektrodensegment auf $L_2 = \frac{m}{N} L$ ein.

Dies gestattet es, auch bei einer geringeren Anzahl von Füllgutbehältern in einem oder jedem der Elektrodensegmente, verglichen mit der maximalen Füllgutbehälterbesetzungszahl während des Plasmabeschichtungsprozesses in jeden der Füllgutbehälter über die Dauer des gesamten Plasmabeschichtungsprozesses dieselbe Energiemenge zu deponieren.

In einer weiteren Ausführungsform stellt die Steuereinheit die Leistung $\bar{L}$ der Hochfrequenz-Strahlung in einem oder jedem Elektrodensegment gemäß

oder basierend auf $\bar{L} = \frac{v}{b} \cdot \frac{m}{N} \cdot L$ ein.

Dies gestattet es, trotz verringerter Transportgeschwindigkeit $v$, im Vergleich zur normalen Betriebsgeschwindigkeit $b$ und/oder verringerter Anzahl der Füllgutbehälter $m$ im Vergleich zur maximalen Füllgutbehälterbesetzungszahl $N$ über die gesamte Dauer des Plasmabeschichtungsprozesses dennoch dieselbe Energiemenge in den zu beschichtenden Füllgutbehältern zu deponieren.

In einer anderen Ausführungsform kann die Steuereinheit die Auskopplung von Hochfrequenz-Strahlung aus den Elektroden des oder jedes Elektrodensegments beenden, wenn entweder die momentane Transportgeschwindigkeit von Füllgutbehältern $0 ms^{-1}$ beträgt, wobei sich zumindest ein Füllgutbehälter, vorzugsweise aber die maximale Füllgutbehälterbesetzungszahl in einem oder jedem der Elektrodensegmente befindet; oder wenn sich kein Füllgutbehälter in einem oder jedem der Elektrodensegmente befindet.

Dies trägt zum einen dazu bei, dass im Falle von Stillstand der Vorrichtung und gleichzeitig in den Elektrodensegmenten verbleibende Füllgutbehälter der Plasmabeschichtungsvorgang gestoppt werden kann, um zu verhindern, dass der Gesamtenergiebetrag, welcher in den Füllgutbehältern deponiert wird, den maximal vorgesehenen Energiebetrag übersteigt, womit Ausschuss minimiert wird. Das macht es möglich, dass die Vorrichtung nach einem Stillstand nicht leer gefahren werden muss und vermindert so den Ausschuss. Darüber hinaus kann im Falle eines leeren Elektrodensegments vermieden werden, dass es aufgrund der eingekoppelten Hochfrequenz-Strahlung zu Beschädigungen mechanischer Bauteile durch elektrische Überschläge kommt.

Unter beispielsweise Verwendung dieser Vorrichtung lässt sich ein Verfahren verwirklichen, bei dem mit Hilfe einer Steuereinheit und einem oder mehreren Elektrodensegmenten Füllgutbehälter, wie insbesondere Flaschen, während eines Plasmabeschichtungsprozesses beschichtet werden können, wobei jedes der Elektrodensegmente mindestens einen Füllgutbehälter aufnimmt und Elektroden zum Auskoppeln von Hochfrequenz-Strahlung umfasst. Das Verfahren zeichnet sich dadurch aus, dass die Plasmabeschichtung durch die Steuereinheit in einem oder jedem der Elektrodensegmente in Abhängigkeit von Prozessparametern automatisch gesteuert wird.

Dies gestattet eine genaue Anpassung des Plasmabeschichtungsprozesses an sich ändernde Prozessparameter und damit eine verringerte Qualitätsstreuung bei der Plasmabeschichtung von Füllgutbehältern, womit Ausschuss verringert wird.

In einer Ausführungsform ist das Verfahren dadurch gekennzeichnet, dass es wahlweise mit einem oder mehreren der folgenden Merkmale realisiert werden kann: ein Geschwindigkeitssensor bestimmt die momentane Geschwindigkeit der zu beschichtenden Füllgutbehälter; oder die Steuereinheit gibt eine momentane Transportgeschwindigkeit $v$ vor und steuert einen Antrieb für die Füllgutbehälter; eine Erfassungseinrichtung für Füllgutbehälter wie etwa eine Lichtschranke übermittelt Signale über das Einfahren von Füllgutbehältern in ein oder jedes Elektrodensegment an die Steuereinheit, die eine Anzahl m der Füllgutbehälter in einem Elektrodensegment bestimmt.

Diese Merkmale ermöglichen durch geeignete Kombination eine große Flexibilität des Verfahrens in Bezug auf sich ändernde Prozessparameter. So lässt sich beispielsweise die Leistung bei geringerer Transportgeschwindigkeit und/oder geringerer Anzahl der Füllgutbehälter in einem oder jedem Elektrodensegment so reduzieren, dass die Energie, welche in den Füllgutbehältern deponiert wird, während sie den gesamten Plasmabeschichtungsprozess durchlaufen, stets dieselbe bleibt. Ferner lässt sich das Entstehen von Sekundärplasmen reduzieren und die Beschädigung mechanischer Bauteile durch Überschläge vermindern. Darüber hinaus lässt sich ein Schmelzen von Füllgutbehältern aufgrund von zu viel deponierter Energie während des Plasmabeschichtungsprozesses vermeiden.

In einer weiteren Ausführungsform ist das Verfahren dadurch gekennzeichnet, dass die Steuereinheit die Auskopplung von Hochfrequenz-Strahlung aus den Elektroden des oder jedes Elektrodensegments beendet, wenn entweder die Transportgeschwindigkeit der Füllgutbehälter $0 ms^{-1}$ beträgt, wobei sich mindestens ein Füllgutbehälter, vorzugsweise aber die maximale Füllgutbehälterbesetzungszahl, in einem oder jedem der Elektrodensegmente befindet; oder, wenn sich kein Füllgutbehälter in einem oder jedem der Elektrodensegmente befindet.

Dies gestattet gerade bei Stillstand der Maschine die Beendigung des Plasmabeschichtungsprozesses, um zu verhindern, dass der in den Füllgutbehältern deponierte Energiebetrag den vorgesehenen Energiebetrag übersteigt. Auf der anderen Seite ermöglicht es im Fall von nicht vorhandenen Füllgutbehältern Beschädigungen von Bauelementen, aufgrund der dennoch eingekoppelten Hochfrequenz-Strahlung, zu verhindern.

## Kurzbeschreibung der Figuren

Fig. 1    Komplette Draufsicht einer bevorzugten Ausführungsform der Vorrichtung.

Fig. 2    Darstellung der Einspeisung der Hochfrequenz-Strahlung bei unterschiedlicher Anzahl von Füllgutbehältern in einem Elektrodensegment.

Fig. 3    Darstellung der Auskopplung von Hochfrequenz-Strahlung bei unterschiedlichen Transportgeschwindigkeiten der Füllgutbehälter.

Fig. 4    Eine weitere bevorzugte Ausführungsform.

Fig. 5    Eine weitere bevorzugte Ausführungsform.

Fig. 6    Darstellung des Plasmabeschichtungsvorgangs

Fig. 7    Eine weitere bevorzugte Ausführungsform.

## Detaillierte Beschreibung

Die Plasmabeschichtung von Produkten, insbesondere Füllgutbehältern, wie Flaschen, wird mittels einer Vorrichtung zum Plasmabeschichten mit einem oder mehreren Elektrodensegmenten und einer Steuereinheit erreicht.

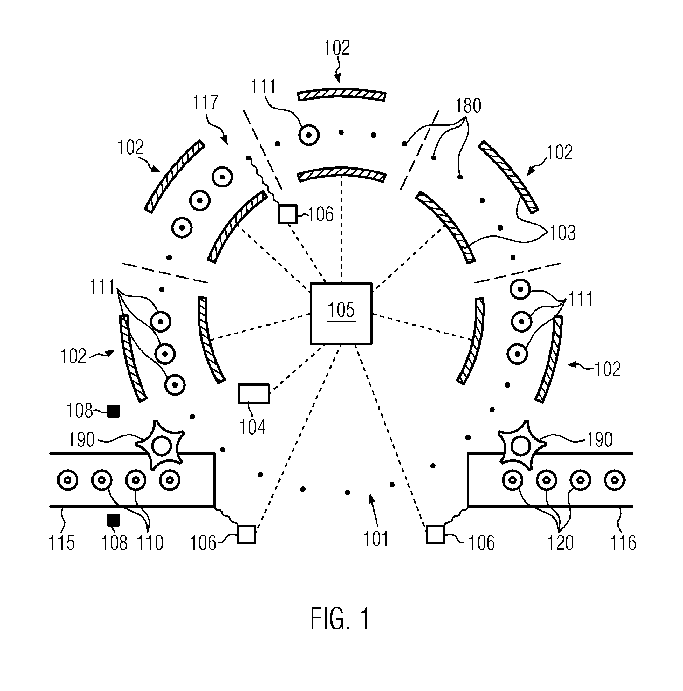

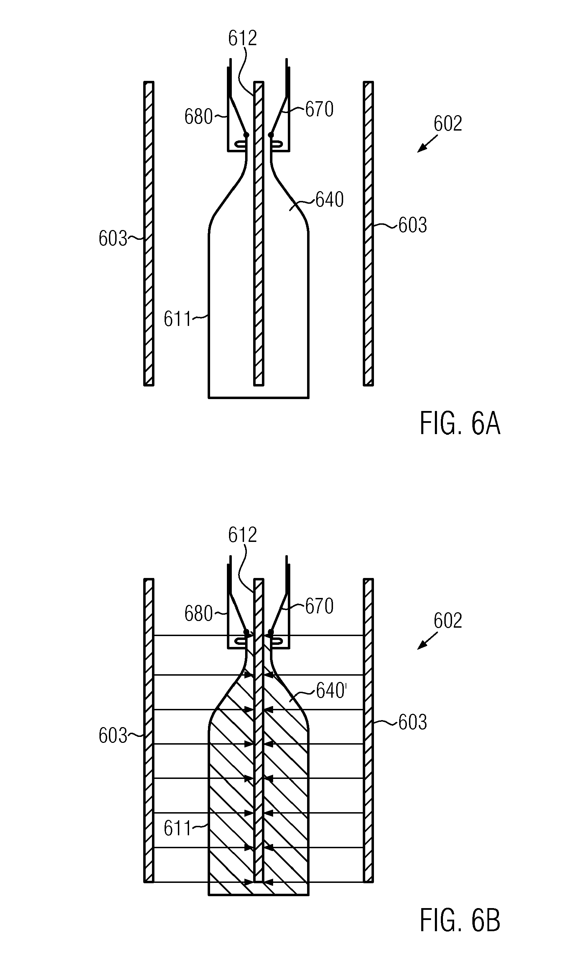

In Fig. 1 ist schematisch der Aufbau einer bevorzugten Ausführungsform einer erfindungsgemäßen Vorrichtung 101 zum Plasmabeschichten von Füllgutbehältern dargestellt. Dabei befinden sich die unbeschichteten Füllgutbehälter 110 auf einem zur Vorrichtung 101 hinführenden Transportband 115. Die unbeschichteten Füllgutbehälter 110 können beispielsweise mittels eines Umlenksterns 190 auf die Beschichtungsstrecke 117, welche durch die Vorrichtung zum Plasmabeschichten 101 führt, umgelagert werden. Befinden sich die zu beschichtenden Füllgutbehälter 111 in der Beschichtungsstrecke 117, welche durch die Vorrichtung zum Plasmabeschichten 101 führt, erfolgt die Fortbewegung der zu beschichtenden Füllgutbehälter vorzugsweise dadurch, dass sie hängend in jeweiligen Halterungen 180 durch die Beschichtungsstrecke transportiert werden. Dabei sind die Halterungen 180 vorzugsweise so konstruiert, dass sie die Füllgutbehälter an den Kragen halten. Die Halterungen 180 in Fig. 1 sind nur schematisch angedeutet. Auf einen bevorzugten Aufbau wird in Fig. 6 Bezug genommen. Die zu beschichtenden Füllgutbehälter 111 durchlaufen mit den Halterungen 180 ein oder mehrere Elektrodensegmente 102, in denen sich vorzugsweise parallel zur Bewegungsrichtung der Füllgutbehälter angebrachte Elektroden 103 befinden. In diesen Elektrodensegmenten 102 findet der Plasmabeschichtungsprozess der zu beschichtenden Füllgutbehälter 111 statt. Nach Durchlaufen der Vorrichtung zum Plasmabeschichten 101 gelangen die nun beschichteten Füllgutbehälter 120 beispielsweise zu einem weiteren Umlenkstern 190, welcher die nun beschichteten Füllgutbehälter 120 aus der Beschichtungsstrecke 117 auf ein von der Vorrichtung zum Plasmabeschichten 101 wegführendes Transportband 116 umlagern kann, wobei vorher die Verbindung der beschichteten Füllgutbehälter 120 zu den Halterungen 180 gelöst wird. Die Transportbänder 115 und 116 werden durch Antriebe 106 angetrieben. Auch die Halterungen 180 in der Beschichtungsstrecke 117 können, wie in der Fig. 1 zu sehen, durch einen solchen Motor angetrieben werden. Die Geschwindigkeit der zu beschichtenden Füllgutbehälter 111 in der Vorrichtung zum Plasmabeschichten 101 wird mittels eines Geschwindigkeitssensors 104 gemessen. Das Einfahren eines unbeschichteten Füllgutbehälters 110 in die Vorrichtung zum Plasmabeschichten 101 wird vorzugsweise mittels einer Erfassungseinrichtung für Füllgutbehälter, wie einer Lichtschranke 108, festgestellt. Eine Steuereinheit 105 kann die Daten des Geschwindigkeitssensors 104 und der Erfassungseinrichtung 108 auswerten und die Elektroden 103 der Elektrodensegmente 102 sowie die Antriebe 106 der Transportbänder 115 und 116, sowie der Halterungen 180 in der Beschichtungsstrecke 117 steuern.

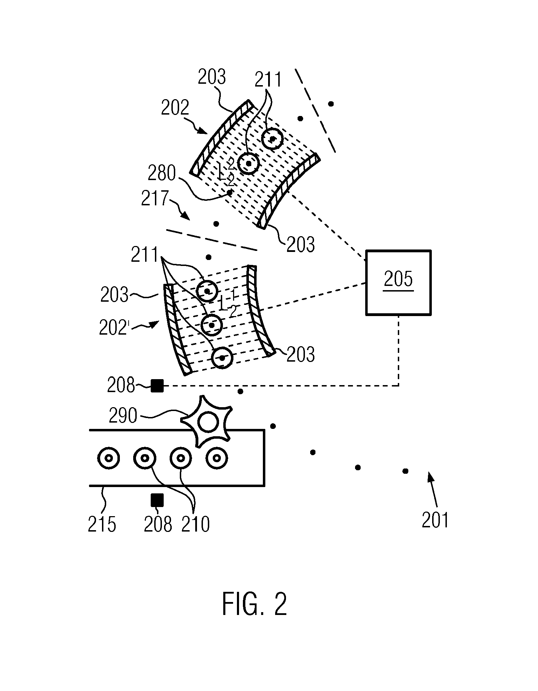

Fig. 2 zeigt den Verlauf des Plasmabeschichtungsprozesses in Abhängigkeit von der Anzahl der zu beschichtenden Füllgutbehälter 211, welche sich während des Plasmabeschichtungsprozesses innerhalb eines oder jedes der Elektrodensegmente 202 befinden. Die von der Transportstrecke 215 beispielsweise durch den Umlenkstern 290 in die Beschichtungsstrecke 217 umgelenkten, unbeschichteten Füllgutbehälter 210 werden durch die Erfassungseinrichtung 208 detektiert. Gibt es in der Reihe der unbeschichteten Füllgutbehälter 210 eine Lücke, so existiert diese Lücke auch im Bereich der Vorrichtung zum Plasmabeschichten 201. Die entsprechende Halterung 280, welche an der Stelle des nicht vorhandenen zu beschichtenden Füllgutbehälters ist, steht nun frei. Das bedeutet, dass die eingekoppelte Hochfrequenz-Strahlung mit ihrer gesamten Leistung $L$ Energie in weniger als der vorgesehenen maximalen Füllgutbehälterbesetzungszahl $N$ deponiert. Damit entfällt auf jeden der übrigen zu beschichtenden Füllgutbehälter 211 in dem entsprechenden Elektrodensegment 202 bei unveränderter Leistung der Hochfrequenzstrahlung mehr Energie als vorgesehen. Um dies zu verhindern, steuert die Steuereinheit 205 nach Auswertung der Signale der Erfassungseinrichtung 208 des Elektrodensegments 202, welches eine Anzahl $m$ von zu beschichtenden Füllgutbehältern 211 enthält, die kleiner ist als die maximale Füllgutbehälterbesetzungszahl $N$ , so dass die eingekoppelte Leistung $L_2^2$ um den Faktor $\dfrac{m}{N}$ kleiner ist als die bei maximaler Füllgutbehälterbesetzungszahl eingekoppelte Leis-N tung. Registriert die Steuereinheit 205 hingegen nach Auswertung der Signale der Lichtschranke 208, dass in einem Elektrodensegment 202' die maximale Füllgutbehälterbesetzungszahl vorhanden ist, das bedeutet also, dass zu jeder zur Verfügung stehenden Halterung 280 ein zu beschichtender Füllgutbehälter 211 vorhanden ist, so wird die bei Normalbetrieb vorgesehene Leistung $L_2^1$ bei der Auskopplung der Hochfrequenzstrahlung verwendet.

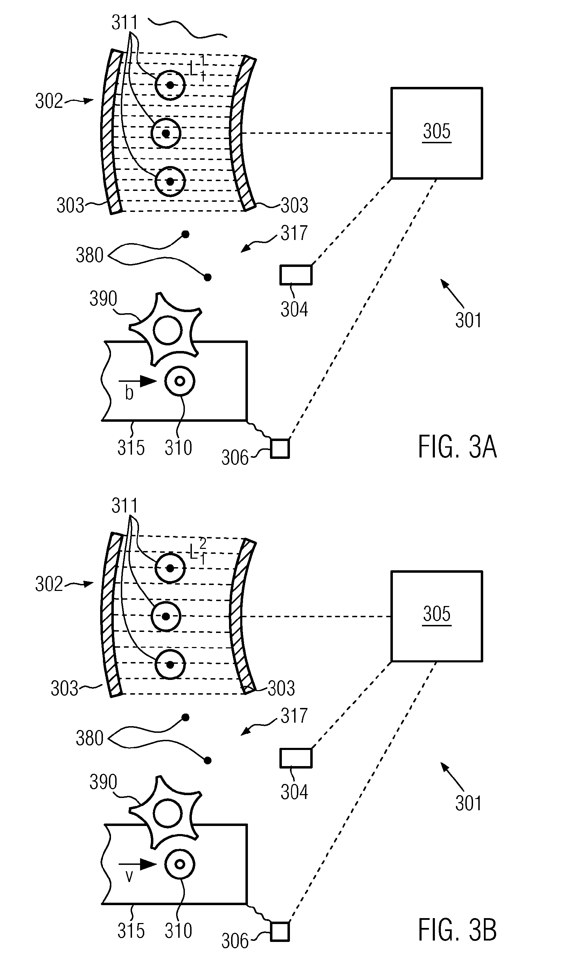

Fig. 3 zeigt den Plasmabeschichtungsprozess in Abhängigkeit von der momentanen Geschwindigkeit $v$ der zu beschichtenden Füllgutbehälter 311. Für diese Abbildung wird daher vereinfachend von der lückenlosen Verfügbarkeit von unbeschichteten Füllgutbehältern 310 in der zur Vorrichtung zur Plasmabeschichtung 301 führenden Transportstrecke 315 ausgegangen. Die unbeschichteten Füllgutbehälter 310 werden erneut möglicherweise durch einen Umlenkstern 390 auf die durch die Vorrichtung zum Plasmabeschichten 301 führende Beschichtungsstrecke 317 umgelenkt und einer Halterung 380 zugeführt, wobei das Transportband 315 und die Halterungen 380 in der Beschichtungsstrecke 317 vorzugsweise dieselbe Geschwindigkeit $v$ aufweisen. Es wird nun Bezug genommen auf Fig. 3A, in welcher sich die unbeschichteten Füllgutbehälter 310 und zu beschichtenden Füllgutbehälter 311 mit der normalen Betriebsgeschwindigkeit b auf dem Transportband 315 und in der Beschichtungsstrecke 317 bewegen. Die Steuereinheit 305 ermittelt entweder durch den Geschwindigkeitssensor 304, dass sich die unbeschichteten Füllgutbehälter 310 und die zu beschichtenden Füllgutbehälter 311 mit der normalen Transportgeschwindigkeit $b$ auf dem Transportband 315 und in der Beschichtungsstrecke 317 bewegen, oder, bestimmt durch Steuerung des Antriebs 306, die Geschwindigkeit, mit der sich die unbeschichteten Füllgutbehälter 310 und die zu beschichtenden Füllgutbehälter 311 auf dem Transportband 315 und in der Beschichtungsstrecke 317 bewegen. In beiden Fällen ist die Geschwindigkeit der Füllgutbehälter gleich der normalen Transportgeschwindigkeit b (Fig. 3A). Befinden sich die zu beschichtenden Füllgutbehälter 311 innerhalb der Vorrichtung zum Plasmabeschichten 301 in einem der oder in dem Elektrodensegment 302, so steuert die Steuereinheit 305 die Auskopplung der Hochfrequenzstrahlung aus den Elektroden 303 in dem Elektrodensegment 302 derart, dass die der normalen Transportgeschwindigkeit b entsprechende Leistung $L_1^1$ ausgekoppelt wird, wodurch innerhalb der durch die normale Transportgeschwindigkeit $b$ bestimmten Verweildauer der zu beschichtenden Füllgutbehälter 311 in dem Elektrodensegment 302 eine vorgegebene Energiemenge in dem Plasma, welches in den zu beschichtenden Füllgutbehältern 311 durch Einkopplung der Hochfrequenzstrahlung gezündet wird, eingekoppelt wird.

Es wird nun auf Fig. 3B Bezug genommen. Hier ist die momentane Transportgeschwindigkeit $v$ der unbeschichteten Füllgutbehälter 310 auf dem Transportband 315 und der zu beschichtende Füllgutbehälter 311 in der Beschichtungsstrecke 317 kleiner als die normale Transportgeschwindigkeit $b$. Eine entsprechende Information erhält die Steuereinheit 305 entweder durch den Geschwindigkeitssensor 304, welcher die Geschwindigkeit der zu beschichtenden Füllgutbehälter 311 in der Beschichtungsstrecke 317 misst oder indem die Steuereinheit 305 direkt den Antrieb 306 des Transportbandes 315 und der Halterungen 380 in der Beschichtungsstrecke 317 steuert und somit die Geschwindigkeit $v < b$ einstellt. Um zu verhindern, dass während der durch die geringere Geschwindigkeit $v$ bedingten längeren Verweildauer der zu beschichtenden Füllgutbehälter 311 in der oder dem Elektrodensegment 302 mehr Energie in das in den zu beschichtenden Füllgutbehältern 311 befindliche Plasma und damit in die zu beschichtenden Füllgutbehälter 311 deponiert wird, kann die Steuereinheit 305 die Elektroden 303 des oder jedes Elektrodensegments 302 derart steuern, dass die von ihnen ausgekoppelte Leistung der Hochfrequenzstrahlung $L_1^2$ um den Faktor $\dfrac{v}{b}$ geringer ist als die in dem zu Fig. 3A gehörigen Plasmabeschichtungsprozess. Dadurch wird erreicht, dass trotz der höheren Verweildauer der zu beschichtenden Füllgutbehälter 311 im Elektrodensegment 302 die Gesamtmenge an in den zu beschichtenden Füllgutbehältern 311 deponierter Energie genau so groß ist wie im normalen Betriebsfall.

Die in Fig. 2 und Fig. 3 beschriebenen Prozesse können durch geeignete Programmierung der Steuereinheit 205 bzw. 305 zu einer resultierenden Leistung $\overline{L}$ kombiniert werden. Aufgrund technischer Grenzen kann die oben beschriebene Einstellung der Leistungen $L_i^j$ durch die Steuereinheit 205 bzw. 305 nicht beliebig genau auf Basis der Vorfaktoren erfolgen. Vorzugsweise ist die Leistung daher stufenweise steuerbar. Das gilt vorzugsweise vor allem für den durch die Anzahl der Füllgutbehälter definierten Vorfaktor $\dfrac{m}{N}$, da hier die möglichen Vorfaktoren und damit die einzustellenden Stufen bei gegebener maximaler Füllgutbehälterbesetzungszahl $N$ bekannt sind und bereits zum Beispiel als gespeicherter Datensatz vorliegen können. Die Anpassung der Leistung an die momentane Transportgeschwindigkeit $v$ ist vorzugsweise mit einer feineren Abstufung möglich, wobei auch hier dem Fachmann klar ist, dass diese Einteilung nicht beliebig genau sein kann. So kann vorgegeben sein, dass die tatsächlich von der Steuerung vorgegebene Leistung in einem Bereich von beispielsweise bis zu 5% oder 10% von den errechneten Leistungen $L_1$, $L_2$, $\overline{L}$ abweicht.

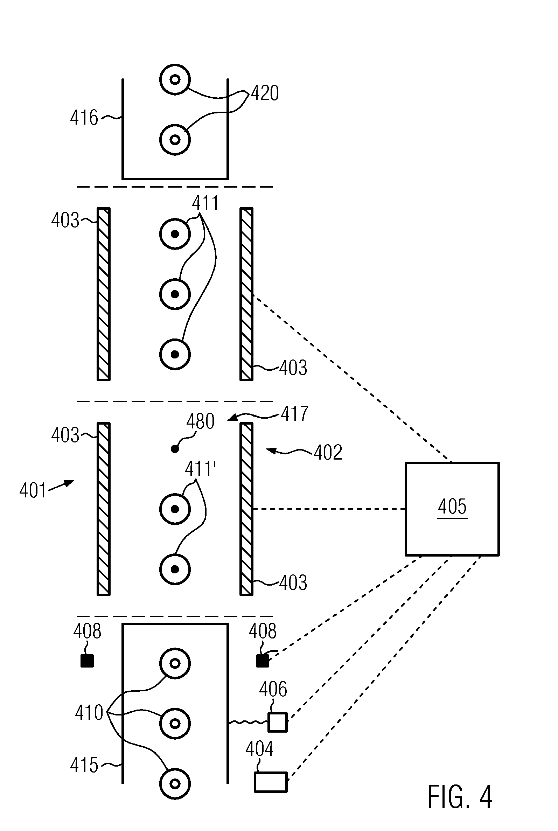

Die Fig. 4 ist eine weitere mögliche Ausführungsform, die eine Vorrichtung zum Plasmabeschichten 401 zu beschichtender Füllgutbehälter 411 darstellt. Dabei sind die Elektrodensegmente 402 und insbesondere die Elektroden 403 parallel zu einer gerade verlaufenden Beschichtungsstrecke 417 angeordnet. Dies kann die Umlenkung von unbeschichteten Füllgutbehältern 410 und beschichteten Füllgutbehältern 420 in den jeweiligen Transportbändern 415 und 416 mit Hilfe von beispielsweise Umlenksternen überflüssig machen.

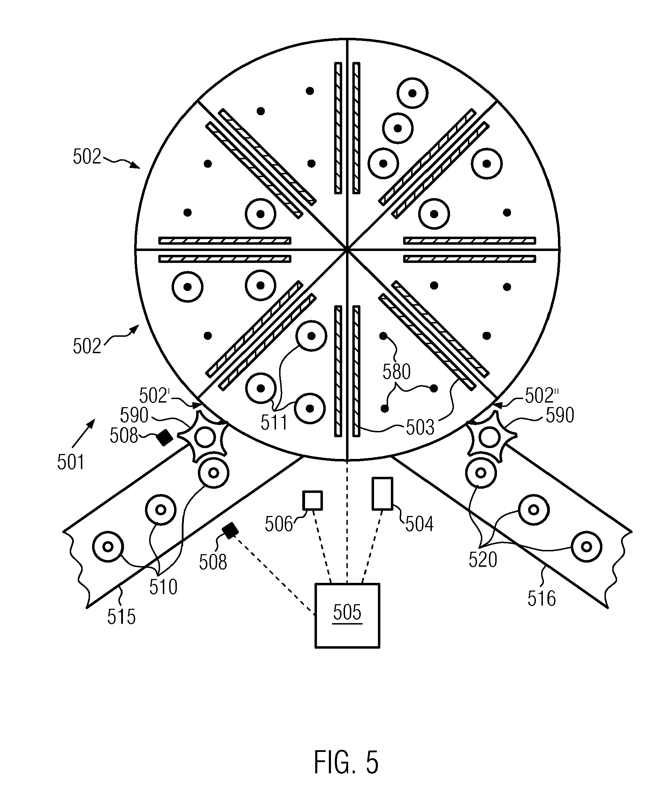

In einer weiteren möglichen Ausführungsform, die in Fig. 5 gezeigt ist, besteht die Vorrichtung zum Plasmabeschichten 501 aus einer Rundläuferschiene, welche in mehrere, mindestens jedoch zwei Elektrodensegmente 502 unterteilt ist. Das Transportband 515, welches die unbeschichteten Füllgutbehälter 510 zur Vorrichtung zum Plasmabeschichten 501 führt und das Transportband 516, welches die beschichteten Füllgutbehälter 520 von der Vorrichtung zum Plasmabeschichten 501 weg führt, sind vorzugsweise so angeordnet, dass das aktuelle Elektrodensegment 502'', welches die beschichteten Füllgutbehälter 520 an das Transportband 516 übergibt, das dem Elektrodensegment 502' benachbart ist, welches die unbeschichteten Füllgutbehälter 510 aus der Transportstrecke 515 aufnimmt. Dadurch wird gewährleistet, dass die zu beschichtenden Füllgutbehälter 511 eine möglichst lange Verweildauer in der Rundläufermaschine haben. Die Anordnung der Elektroden 503, der zu beschichtenden Füllgutbehälter 511, sowie der Halterungen 580 ist hier zu Anschauungszwecken gewählt. Einem Fachmann wäre klar, dass es andere, gegebenenfalls besser geeignete Möglichkeiten zur Anordnung der Elektroden 503, der Halterungen 580 und der zu beschichtenden Füllgutbehälter 511 innerhalb eines oder jedes Elektrodensegments 502 gibt. Auch die Positionierung der Transportbänder 515 und 516 in Relation zur Vorrichtung zum Plasmabeschichten 501 dient hier nur der Illustration. So wäre es beispielsweise auch denkbar, dass die Transportbänder 515 und 516 senkrecht zur Zeichenebene und zur Rundläufermaschine laufen und die Flaschen durch mögliche Umlenksterne 590 in die Elektrodensegmente 502 eingeführt werden.

Fig. 6 zeigt eine mögliche Ausführungsform des Vorgangs des Plasmabeschichtens eines zu beschichtenden Füllgutbehälters 611 in einem der Elektrodensegmente 602. In Fig. 6A ist ein zu beschichtender Füllgutbehälter 611 dargestellt, in welchem eine Lanze 612, welche sich in jeder Halterung 680 befindet, eingeführt ist. Weiterhin wird der Kragen des zu beschichtenden Füllgutbehälters 611 von der Halterung 680 umfasst. Innerhalb der Halterung 680 kann eine Prozessgaseinheit 670, welche beispielsweise mit Hilfe eines Ventils an die Öffnung des zu beschichtenden Füllgutbehälters 611 gekoppelt sein kann, für die Zufuhr des Prozessgases 640 zum Plasmabeschichten und eine Evakuierung für eine im Vergleich zum Außenraum des zu beschichtenden Füllgutbehälters 611 geringe Dichte des Prozessgases 640 sorgen. In Fig. 6B wird zwischen die Lanze 612 und die Elektroden 603 ein elektrisches Feld angelegt, so dass Hochfrequenzstrahlung vorgegebener Leistung $L$ ausgekoppelt werden kann. Dabei dient die Lanze 612 als eine weitere Elektrode. Dabei kann die Hochfrequenzstrahlung entweder von den Elektroden 603 ausgekoppelt werden, wobei die Lanze 612 geerdet ist, oder die Hochfrequenzstrahlung kann von der Lanze 612 ausgekoppelt werden, wobei dann die Elektroden 603 geerdet sind.

Aufgrund der geringen Teilchendichte des Prozessgases 640' innerhalb des zu beschichtenden Füllgutbehälters 611 wird die Leistung $L$ der Hochfrequenzstrahlung durch Zünden eines Plasmas des Prozessgases 640' umgesetzt. Da die für die Zündung eines Plasmas des Prozessgases 640' notwendigen Bedingungen vorzugsweise nur innerhalb des zu beschichtenden Füllgutbehälters 611 gegeben sind, wird die vollständige Leistung *L* der Hochfrequenzstrahlung nur innerhalb des Füllgutbehälters umgesetzt.

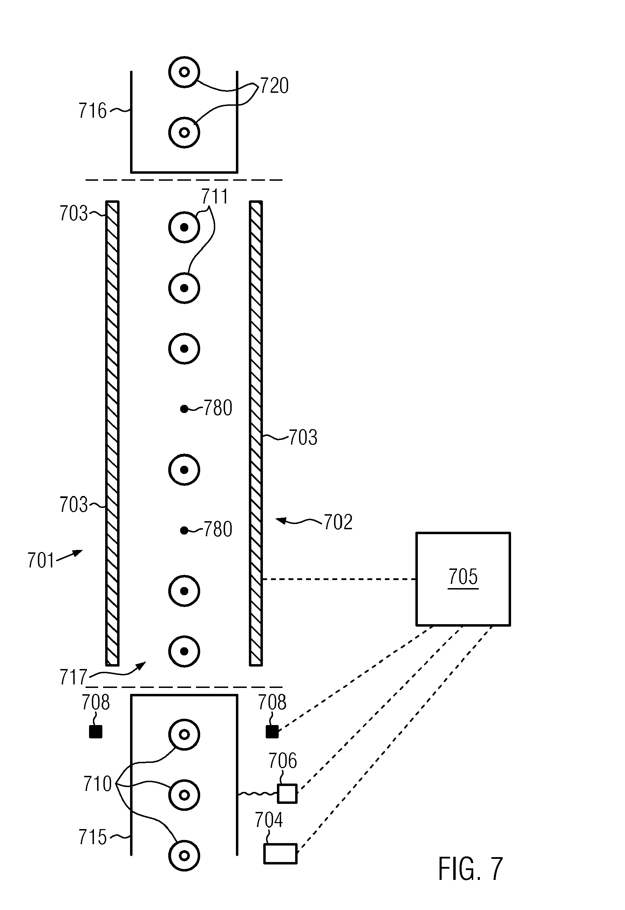

Fig. 7 zeigt eine weitere mögliche Ausführungsform der Vorrichtung zum Plasmabeschichten 701. Dabei besteht die Vorrichtung 701 aus nur einem Elektrodensegment 702, in welchem Halterungen 780 für zu beschichtende Füllgutbehälter 711 geführt werden. Auch hier erfolgt die Bestimmung des Einlaufens eines unbeschichteten Füllgutbehälters 710 aus der Transportstrekke 715 in die Beschichtungsstrecke 717 innerhalb der Vorrichtung zum Plasmabeschichten 701 vorzugsweise mittels einer Erfassungseinrichtung für Füllgutbehälter, wie beispielsweise einer Lichtschranke 708. Die Messung der Transportgeschwindigkeit der Füllgutbehälter kann mittels eines Geschwindigkeitssensors 704 erfolgen. Des Weiteren werden Transportbänder 715 und 716, ebenso wie die Halterungen 780, mittels eines Antriebs 706 angetrieben. Die Steuerung der Elektroden 703, die Auswertung der Signale der Erfassungseinrichtung 708 und des Geschwindigkeitssensors 704 sowie die Steuerung des Antriebs 706 erfolgt mittels einer Steuereinheit 705.

**Patentansprüche**

1. Eine Vorrichtung zur Plasmabeschichtung von Füllgutbehältern, insbesondere Flaschen, wobei die Vorrichtung vorzugsweise eine Rundläufermachine ist, welche eine Steuereinheit, ein oder mehrere Elektrodensegmente zum Plasmabeschichten, von denen jedes zumindest einen Füllgutbehälter aufnehmen kann, und Elektroden zum Auskoppeln von Hochfrequenz-Strahlung umfasst, **dadurch gekennzeichnet, dass:**

   die Steuereinheit die Plasmabeschichtung in einem oder jedem der Elektrodensegmente bzw. in auswählbaren Elektrodensegmenten automatisch abhängig von Prozessparametern steuern kann.

2. Die Vorrichtung aus Anspruch 1, **dadurch gekennzeichnet, dass** die Steuereinheit die Leistung der Hochfrequenz-Strahlung auf Werte zwischen 0W und dem Wert *L*, welcher bei maximaler Füllgutbehälterbesetzungszahl *N* und normaler Betriebsgeschwindigkeit *b* verwendet wird, einstellen kann.

3. Die Vorrichtung aus den Ansprüchen 1 oder 2, **dadurch gekennzeichnet, dass** ein Geschwindigkeitssensor vorgesehen ist, welcher eine momentane Transportgeschwindigkeit *v* der Füllgutbehälter messen kann und den Wert an die Steuereinheit weitergeben kann oder die Steuereinheit eine momentane Transportgeschwindigkeit *v* vorgeben und einen Antrieb für die Füllgutbehälter steuern kann.

4. Die Vorrichtung aus Anspruch 3, **dadurch gekennzeichnet, dass:**

   die Steuereinheit die Leistung der Hochfrequenz-Strahlung in einem oder jedem der Elektrodensegmente in Abhängigkeit von der momentanen Transportgeschwindigkeit *v* der Füllgutbehälter, wie etwa der Rotationsgeschwindigkeit in der Rundläufermachine, steuern kann.

5. Die Vorrichtung aus Anspruch 4, **dadurch gekennzeichnet, dass** die Steuereinheit die Leistung $L_1$ der Hochfrequenz-Strahlung gemäß oder basierend auf dem Verhältnis $\dfrac{v}{b}$ aus momentaner Transportgeschwindigkeit *v* und normaler Betriebsgeschwindigkeit *b* auf $L_1 = \dfrac{v}{b} L$ einstellen kann.

6. Die Vorrichtung aus einem der Ansprüche 1 bis 5, **dadurch gekennzeichnet, dass** zumindest eine Erfassungseinrichtung für Füllgutbehälter, wie eine Lichtschranke, vorgesehen ist, welche Signale über das Einfahren von Füllgutbehältern in ein oder jedes Elektrodensegment an die Steuereinheit übermitteln kann, welche, basierend auf diesen Signalen, eine Anzahl *m* der Füllgutbehälter in einem oder jedem Elektrodensegment bestimmen kann.

7. Die Vorrichtung aus Anspruch 6, **dadurch gekennzeichnet, dass:**

   die Steuereinheit die Leistung der Hochfrequenz-Strahlung in einem oder jedem der Elektrodensegmente in Abhängigkeit von der Anzahl *m* der Füllgutbehälter in einem oder jedem der Elektrodensegmente steuern kann.

8. Die Vorrichtung aus Anspruch 7, **dadurch gekennzeichnet, dass** die Steuereinheit die Leistung $L_2$ der Hochfrequenz-Strahlung in einem oder jedem Elektrodensegment gemäß oder basierend auf dem Verhältnis $\dfrac{m}{N}$ aus der Anzahl der Füllgutbehälter *m* in einem oder jedem Elektrodensegment und der maximalen Füllgutbehälterbesetzungszahl *N* in einem oder jedem Elektrodensegment auf $L_2 = \dfrac{m}{N} L$ einstellen kann.

**9.** Die Vorrichtung aus einem der Ansprüche 1 bis 8, **dadurch gekennzeichnet, dass** die Steuereinheit die Leistung $\overline{L}$ der Hochfrequenz-Strahlung in einem oder jedem Elektrodensegment gemäß oder basierend auf $\overline{L} = \dfrac{v}{b} \cdot \dfrac{m}{N} \cdot L$ einstellen kann.

**10.** Die Vorrichtung aus einem der Ansprüche 1 bis 9, **dadurch gekennzeichnet, dass** die Steuereinheit die Auskopplung von Hochfrequenz-Strahlung aus den Elektroden beenden kann, wenn:

die momentane Transportgeschwindigkeit von Füllgutbehältern $v = 0 ms^{-1}$ beträgt, wobei sich mindestens ein Füllgutbehälter, vorzugsweise die maximale Füllgutbehälterbesetzungszahl $N$ in einem oder jedem der Elektrodensegmente befindet; oder sich kein Füllgutbehälter in einem oder jedem Elektrodensegment befindet.

**11.** Ein Verfahren zum Plasmabeschichten von Füllgutbehältern, insbesondere Flaschen, mit Hilfe einer Vorrichtung, welche eine Steuereinheit und eines oder mehrere Elektrodensegmente zum Plasmabeschichten, von denen jedes mindestens einen Füllgutbehälter aufnimmt, und Elektroden zum Auskoppeln von Hochfrequenz-Strahlung umfasst, **dadurch gekennzeichnet, dass:** die Plasmabeschichtung durch die Steuereinheit in einem oder jedem Elektrodensegment in Abhängigkeit von Prozessparametern automatisch gesteuert wird.

**12.** Das Verfahren aus Anspruch 11, **dadurch gekennzeichnet, dass:**

ein Geschwindigkeitssensor die momentane Transportgeschwindigkeit $v$ der Füllgutbehälter bestimmt; und/oder die Steuereinheit eine momentane Transportgeschwindigkeit $v$ vorgibt und einen Antrieb für die Füllgutbehälter steuert; und/oder eine Erfassungseinrichtung für Füllgutbehälter, wie eine Lichtschranke, Signale über das Einfahren von Füllgutbehältern in ein oder jedes Elektrodensegment an die Steuereinheit übermittelt, die eine Anzahl $m$ der Füllgutbehälter in einem Elektrodensegment bestimmt.

**13.** Das Verfahren aus den Ansprüchen 11 oder 12, **dadurch gekennzeichnet, dass:**

die Steuereinheit die Leistung der Hochfrequenz-Strahlung in einem oder jedem der Elektrodensegmente in Abhängigkeit von der momentanen Transportgeschwindigkeit $v$ der Füllgutbehälter, der normalen Betriebsgeschwindigkeit $b$, der Anzahl $m$ der Füllgutbehälter in einem oder jedem Elektrodensegment und der maximalen Füllgutbehälterbesetzungszahl $N$ in einem oder jedem Elektrodensegment einstellt.

**14.** Das Verfahren aus den Ansprüche 11 bis 13, **dadurch gekennzeichnet, dass:**

die Steuereinheit die Auskopplung von Hochfrequenz-Strahlung aus den Elektroden beendet, wenn:

die Transportgeschwindigkeit der der Füllgutbehälter $v = 0 ms^{-1}$ beträgt, wobei sich mindestens ein Füllgutbehälter, vorzugsweise die maximale Füllgutbehälterbesetzungszahl $N$ in einem oder jedem der Elektrodensegmente befindet; oder wenn sich kein Füllgutbehälter in einem oder jedem Elektrodensegment befindet.

FIG. 1

FIG. 2

FIG. 3A

FIG. 3B

FIG. 4

FIG. 5

FIG. 6A

FIG. 6B

FIG. 7

Europäisches Patentamt
European Patent Office
Office européen des brevets

**EUROPÄISCHER RECHERCHENBERICHT**

Nummer der Anmeldung

EP 12 19 5810

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2009/188430 A1 (MATSUDA SATOSHI [JP] ET AL) 30. Juli 2009 (2009-07-30) * Absätze [0039], [0042], [0044], [0058], [0020] - [0029] - Absatz [0030]; Abbildungen 1,2 * | 1,11 | INV. C23C16/04 B65D23/02 C23C16/52 |
| X | US 2010/034985 A1 (KRUEGER JOCHEN [DE] ET AL) 11. Februar 2010 (2010-02-11) * Absätze [0002], [0003], [0053], [0063], [0075]; Abbildung 5 * | 1,11 | |
| Y | EP 1 605 077 A2 (SCHOTT AG [DE]) 14. Dezember 2005 (2005-12-14) * Absatz [0033] * | 6-8,10, 12,14 | |
| X | DE 10 2004 042431 A1 (SCHOTT AG [DE]) 16. März 2006 (2006-03-16) * Absätze [0001], [0002], [0016], [0041], [0052]; Abbildung 1 * | 1,2,11 | |
| X | DE 10 2010 000940 A1 (KRONES AG [DE]) 21. Juli 2011 (2011-07-21) | 1,11 | RECHERCHIERTE SACHGEBIETE (IPC) |
| Y | * Absätze [0001], [0002], [0035], [0069]; Abbildung 5 * | 3,6-8, 10,12,14 | C23C B65D H05H |
| Y | WO 95/22413 A1 (COCA COLA CO [US]) 24. August 1995 (1995-08-24) * Seite 14, Zeile 12 - Zeile 19 * | 3 | B05D |
| A | WO 93/24243 A1 (POLAR MATERIALS INC [US]) 9. Dezember 1993 (1993-12-09) * Seite 10, Zeile 5 - Zeile 12 * | 1 | |

Der vorliegende Recherchenbericht wurde für alle Patentansprüche erstellt

| Recherchenort | Abschlußdatum der Recherche | Prüfer |
|---|---|---|
| Den Haag | 25. Juni 2013 | Kudelka, Stephan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 12 19 5810

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-06-2013

| Im Recherchenbericht angeführtes Patentdokument | Datum der Veröffentlichung | Mitglied(er) der Patentfamilie | Datum der Veröffentlichung |
|---|---|---|---|
| US 2009188430 A1 | 30-07-2009 | AU 2006211246 A1 | 10-08-2006 |
| | | AU 2010206014 A1 | 19-08-2010 |
| | | CN 101163819 A | 16-04-2008 |
| | | CN 102031504 A | 27-04-2011 |
| | | DE 112006000320 T5 | 10-01-2008 |
| | | JP 4789234 B2 | 12-10-2011 |
| | | JP 2006213967 A | 17-08-2006 |
| | | KR 20070106743 A | 05-11-2007 |
| | | TW 201108868 A | 01-03-2011 |
| | | US 2009188430 A1 | 30-07-2009 |
| | | WO 2006082731 A1 | 10-08-2006 |
| US 2010034985 A1 | 11-02-2010 | CN 101645386 A | 10-02-2010 |
| | | DE 102008037159 A1 | 11-02-2010 |
| | | EP 2151510 A1 | 10-02-2010 |
| | | US 2010034985 A1 | 11-02-2010 |
| EP 1605077 A2 | 14-12-2005 | DE 102004028369 A1 | 05-01-2006 |
| | | EP 1605077 A2 | 14-12-2005 |
| | | JP 2005350145 A | 22-12-2005 |
| | | US 2005284550 A1 | 29-12-2005 |
| DE 102004042431 A1 | 16-03-2006 | AT 412971 T | 15-11-2008 |
| | | DE 102004042431 A1 | 16-03-2006 |
| | | EP 1630848 A1 | 01-03-2006 |
| | | JP 5179713 B2 | 10-04-2013 |
| | | JP 2006083468 A | 30-03-2006 |
| | | US 2006051520 A1 | 09-03-2006 |
| DE 102010000940 A1 | 21-07-2011 | KEINE | |
| WO 9522413 A1 | 24-08-1995 | AT 179914 T | 15-05-1999 |
| | | BR 9505649 A | 19-03-1996 |
| | | CO 4370034 A1 | 07-10-1996 |
| | | DE 69509597 D1 | 17-06-1999 |
| | | DE 69509597 T2 | 16-12-1999 |
| | | DK 693975 T3 | 01-11-1999 |
| | | EP 0693975 A1 | 31-01-1996 |
| | | ES 2131810 T3 | 01-08-1999 |
| | | JP 3553959 B2 | 11-08-2004 |
| | | JP H08509166 A | 01-10-1996 |
| | | NO 954105 A | 16-10-1995 |
| | | US 5849366 A | 15-12-1998 |
| | | US 6276296 B1 | 21-08-2001 |
| | | WO 9522413 A1 | 24-08-1995 |
| | | ZA 9501048 A | 12-10-1995 |

EPO FORM P0461

Für nähere Einzelheiten zu diesem Anhang : siehe Amtsblatt des Europäischen Patentamts, Nr.12/82

**ANHANG ZUM EUROPÄISCHEN RECHERCHENBERICHT
ÜBER DIE EUROPÄISCHE PATENTANMELDUNG NR.**

EP 12 19 5810

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-06-2013

| Im Recherchenbericht angeführtes Patentdokument | Datum der Veröffentlichung | Mitglied(er) der Patentfamilie | Datum der Veröffentlichung |
|---|---|---|---|
| WO 9324243        A1 | 09-12-1993 | AU        666389 B2 | 08-02-1996 |
|  |  | AU       4403093 A | 30-12-1993 |
|  |  | CA       2112102 A1 | 09-12-1993 |
|  |  | EP       0601166 A1 | 15-06-1994 |
|  |  | JP     H07502561 A | 16-03-1995 |
|  |  | PL        302309 A1 | 25-07-1994 |
|  |  | US       5378510 A | 03-01-1995 |
|  |  | US       5645643 A | 08-07-1997 |
|  |  | US       5704983 A | 06-01-1998 |
|  |  | WO       9324243 A1 | 09-12-1993 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004028369
- WO 03100120 A
- DE 102005015063